**Europäisches Patentamt**

**European Patent Office**

**Office européen des brevets**

(11) Veröffentlichungsnummer: **0 376 017**
**A2**

(12) **EUROPÄISCHE PATENTANMELDUNG**

(21) Anmeldenummer: **89122629.2**

(22) Anmeldetag: **08.12.89**

(51) Int. Cl.5: **H01J 37/34, C23C 14/34**

(30) Priorität: **28.12.88 DE 3844064**

(43) Veröffentlichungstag der Anmeldung:
**04.07.90 Patentblatt 90/27**

(84) Benannte Vertragsstaaten:
**AT BE CH DE FR GB IT LI NL SE**

(71) Anmelder: **LEYBOLD AKTIENGESELLSCHAFT**
**Wilhelm-Rohn-Strasse 25**
**D-6450 Hanau am Main 1(DE)**

(72) Erfinder: **Aichert, Hans, Dr.**
**Westbahnhofstrasse 15**
**D-6450 Hanau am Main(DE)**
Erfinder: **Gegenwart, Rainer, Dr.**

Bruchwiesenstrasse 69a
**D-6074 Rödermark(DE)**
Erfinder: **Kukla, Reiner**
**Bühlweg 7**
**D-6450 Hanau am Main 9(DE)**
Erfinder: **Wilmes, Klaus**
**Faulhaberstrasse 6**
**D-6482 Bad Orb(DE)**
Erfinder: **Kieser, Jörg, Dr.**
**Pautzfelder Strasse 19c**
**D-8550 Forchheim(DE)**

(74) Vertreter: **Zapfe, Hans, Dipl.-Ing.**
**Am Eichwald 7, Postfach 20 01 51**
**D-6056 Heusenstamm 2 (Rembrücken)(DE)**

(54) **Katodenzerstäubungsvorrichtung nach dem Magnetron-Prinzip mit einer Hohlkatode und einem zylindrischen Target.**

(57) Katodenzerstäubungsvorrichtung mit einer Hohlkatode nach dem Magnetron-Prinzip mit einem Katodengrundkörper (5), in dem ein hohles Target (9) mit einer zylindrischen Zerstäubungsfläche (10) und einer zylindrischen Außenfläche angeordnet ist. Der Katodengrundkörper (5) besitzt einen Kühlkanal (6). Das Target ist außen von einem Magnetsystem (18) mit Magnetpolen für die Erzeugung eines rotationssymmetrischen, auf dem Umfang und über der Zerstäubungsfläche geschlossenen Tunnels aus magnetischen Feldlinien umgeben. Außerhalb des von der Zerstäubungsfläche (10) umschlossenen Raumes ist mindestens eine Anode (3, 4) angeordnet. Durch das Target (9) und die mindestens eine Anode ist ein Transportweg für ein zu beschichtendes Substrat hindurchgeführt. Zur Lösung der Aufgabe, einen Rohrabschnitt als Target verwenden und dieses mit hohem Materialwirkungsgrad zerstäuben zu können, wird folgende Bauweise angewendet:

Der mindestens eine Kühlkanal (6) ist in Richtung auf das Target (9) durch eine Wand (7) dicht abgeschlossen. Das Target (9) liegt aufgrund eines engen Spiels spätestens bei Erreichen seiner Betriebstemperatur im Wärmeschluß an der Wand (7)

an. Die einen Polflächen (N) des Magnetsystems (18) liegen in Achsrichtung diesseits und die anderen Polflächen (S) in Achsrichtung jenseits der Stirnflächen des Targets (9) und in radialer Richtung auf einem Radius, der gleich oder größer ist als der Radius der Zerstäubungsfläche (10). Das Magnetsystem (18) ist im Betrieb durch Isolierabstände (11, 19, 20) auf einem frei einstellbaren ("floatenden") Potential gehalten.

FIG.1

## Katodenzerstäubungsvorrichtung nach dem Magnetron-Prinzip mit einer Hohlkatode und einem zylindrischen Target

Die Erfindung betrifft eine Katodenzerstäubungsvorrichtung mit

a) einer Hohlkatode nach dem Magnetron-Prinzip mit einem mindestens einen Kühlkanal aufweisenden Katodengrundkörper mit einer inneren zylindrischen Aufnahmefläche für ein hohles Target mit einer inneren, gleichfalls im wesentlichen zylindrischen Zerstäubungsfläche und einer zylindrischen Außenfläche, mit einem den Katodengrundkörper außen umgebenden Magnetsystem mit Magnetpolen für die Erzeugung eines rotationssymmetrischen, auf dem Umfang und über der Zerstäubungsfläche geschlossenen Tunnels aus magnetischen Feldlinien,

b) mindestens einer zur Zerstäubungsfläche im wesentlichen koaxialen und außerhalb des von der Zerstäubungsfläche umschlossenen Raumes liegende Anode, und

c) mit einem koaxial durch das Target und die mindestens eine Anode hindurchgeführten Transportweg für ein zu beschichtendes Substrat.

Durch die DE-OS 22 43 708 sind derartige Katodenzerstäubungsvorrichtungen bekannt, bei denen das im Betrieb auftretende Plasma auf sechs Seiten eingeschlossen ist, von denen vier Seiten durch das Target und die magnetischen Feldlinien und die beiden restlichen Seiten durch die ringförmige Zusammenführung des magnetischen Tunnels gebildet werden. Magnetronkatoden gehorchen der Bedingung E x B, wobei E das elektrische und B das magnetische Feld definieren. Die Zerstäubungsrate ist dort am höchsten, wo die Feldlinien für E und B sich rechtwinklig kreuzen und die Magnetfeldlinien parallel zur Targetoberfläche verlaufen.

Bei einem Teil der Ausführungsbeispiele für Hohlmagnetrons nach der DE-OS 22 43 708 werden im Bereich der Zerstäubungsflächen weitgehend achsparallele Ausschnitte der Magnetfeldlinien verwendet. Da hier weitgehend überall die Bedingung E x B optimal erfüllt ist, wird das Targetmaterial sehr gleichförmig abgetragen. Der dadurch mögliche, sehr hohe Materialwirkungsgrad wird jedoch durch den erheblichen Nachteil erkauft, daß das Target - um der Vier-Seiten-Bedingung zu genügen - radial einwärts gerichtete Flanschen aus Targetmaterial aufweisen muß. Dadurch wird das Target teuer und unterliegt einer ungleichmäßigen Wärmeausdehnung bei zusätzlichem Wärmeeintritt, weil die Flanschen gewissermaßen als "Heizrippen" wirken.

Bei einem weiteren Teil der Ausführungsbeispiele für Hohlmagnetrons nach der DE-OS 22 43 708 wird die Vier-Seiten-Bedingung dadurch erfüllt, daß die Magnetfeldlinien sehr stark gekrümmt sind, aus den zylindrischen bzw. konischen Zerstäubungsflächen an einer Stelle austreten und nach dem Durchlaufen bogenförmiger Bahnen an einer anderen Stelle wieder eintreten. Dadurch ist die Bedingung E x B optimal nur im Bereich von kreisförmigen Linien erfüllt, die durch die über der Zerstäubungsfläche liegenden Kulminationspunkte der Magnetfeldlinien hindurchgehen, weil diese nur in der Nähe der Kulminationspunkte wenigstens angenähert parallel zur Targetoberfläche verlaufen. Dies ermöglicht zwar die Fertigung geometrisch einfacher, weil hohlzylindrischer Targets, ist aber von dem erheblichen Nachteil begleitet, daß die Materialabtragung überwiegend unter den besagten Kulminationspunkten bzw. -linien erfolgt, so daß im Target auf dessen Innenumfang tiefe Erosionsgräben gebildet werden, die sehr bald zum Ausfall des Targets und damit zu einem schlechten Materialwirkungsgrad führen. Der örtliche Wärmeeingang entspricht dabei der örtlichen Zerstäubungsrate, so daß die linienförmig erodierten hohlzylindrischen Targets einer wenn auch geringen, aber doch den Wärmeübergang zwischen Übertragungsflächen störenden tonnenförmigen Verformung unterliegen.

In beiden Fällen liegen daher schlechte Kühlbedingungen für das Target vor, so daß man zu der Lösung greifen mußte, das Target an seiner Außenfläche unmittelbar dem Kühlmedium (Wasser) auszusetzen. Dies führt jedoch wiederum zu Abdichtproblemen zwischen dem Katodengrundkörper und dem Target, wobei zu beachten ist, daß Katodenzerstäubungsprozesse unter Vakua zwischen etwa $10^{-2}$ und $10^{-4}$ mbar ablaufen, so daß bereits kleinste Leckagen zu einem Zusammenbruch des Vakuums und/oder zu einer Kontaminierung der hergestellten Produkte führen. Ein Targetwechsel gestaltet sich dabei außerordentlich schwierig und zeitraubend.

Der Erfindung liegt die Aufgabe zugrunde, eine Katodenzerstäubungsvorrichtung der eingangs beschriebenen Gattung anzugeben, bei der das Target mit einem hohen Materialwirkungsgrad bei hoher Zerstäubungsrate und intensiver Kühlung ohne direkte Berührung mit einem Kühlmedium zerstäubt werden kann und bei der das Target ohne hohen Zerspanungsaufwand aus einfachen und billigen Rohrabschnitten hergestellt werden kann.

Die Lösung der gestellten Aufgabe erfolgt bei der eingangs beschriebenen Katodenzerstäubungsvorrichtung erfindungsgemäß dadurch, daß

d) der mindestens eine Kühlkanal in Richtung auf das Target durch eine zum Katodengrundkörper gehörende Wand mit zylindrischer Innenfläche dicht abgeschlossen ist,

e) das rohrförmige Target mit derart engem Spiel axial in der zylindrische Innenfläche der Wand eingeschoben ist, daß das Target spätestens bei Erreichen seiner Betriebstemperatur im Wärmeschluß an der Wand anliegt,

f) das Magnetsystem aus einem rotationssymmetrischen, zum Target konzentrischen, mit radial einwärts gerichteten Permanentmagneten besetzten Magnetjoch besteht und ringförmig geschlossene Polflächen entgegengesetzter Polarität (N, S) aufweist, von denen die einen Polflächen (N) in Achsrichtung diesseits und die anderen Polflächen (S) in Achsrichtung jenseits der Stirnflächen des Targets und in radialer Richtung auf einem Radius liegen, der gleich oder größer ist als der Radius der Zerstäubungsfläche, und daß

g) das Magnetsystem durch Isolierabstände in an sich bekannter Weise auf einem gegenüber dem Target und dem Katodengrundkörper einerseits und dem Anodenpotential andererseits frei einstellbaren ("floatenden") Potential haltbar ist.

Durch das Merkmal d) wird erreicht, daß das Target ohne Öffnen des Kühlkanals bzw. Kühlkreislaufs ausgetauscht werden kann.

Das Merkmal e) beschreibt zunächst ein rohrförmiges Target ohne radiale Vorsprünge, so daß es in einfachster Weise aus rohrförmigem Material hergestellt werden kann. Durch das enge Spiel und die unvermeidbare Wärmebelastung des Targets wird erreicht, daß das Target nach einer Anlaufzeit intensiv gekühlt wird, und zwar ohne unmittelbare Umspülung durch ein Kühlmedium wie Wasser. Man kann diesen Kühleffekt noch dadurch steigern, daß man die den Kühlkanal nach innen abschließende hohlzylindrische Wand nach Art einer Membran sehr dünnwandig ausbildet, so daß sie durch den Wasserdruck geringfügig bombiert und dadurch an das Target angepreßt wird. Man kann dadurch den Eintritt des Wärmegleichgewichts in Richtung auf niedrigere Temperaturen gezielt verschieben. In der Praxis hat sich eine Wandstärke zwischen und 1 und 2,5 mm als besonders zweckmäßig erwiesen.

Durch das Merkmal f) wird erreicht, daß derjenige Teil der magnetischen Feldlinien, der in dem zylindrischen Volumen innerhalb der Targetfläche verläuft, nur wenig gekrümmt ist, so daß das Target über seine gesamte Zylinderfläche sehr gleichmäßig abgetragen wird. Präziser ausgedrückt handelt es sich um diejenigen Abschnitte der magnetischen Feldlinien, die zwischen den beiden Ebenen verlaufen, in denen auch die ringförmigen Stirnflächen des Targets liegen. Hierdurch wird ein bei rohrförmigen Targets sonst nicht zu erreichender Materialwirkungsgrad bzw. Ausnutzungsgrad erreicht. Weiterhin wird dadurch erreicht, daß beim reaktiven Zerstäuben isolierender Schichten an der gesamten auf Potential liegenden Targetoberfläche eine Netto-Erosion stattfindet, so daß keine nichtleitenden Bereiche durch Selbstbeschichung der Katode entstehen.

Vereinfacht ausgedrückt besagt das Merkmal f), daß der Abstand zwischen den Magnetpolen bzw. Polflächen entgegengesetzter Polarität größer ist als die axiale Ausdehnung des Katodengrundkörpers bzw. des Targets. Allein dadurch ist der Krümmungsradius der Magnetfeldlinien größer. Außerdem kann durch diese Bauweise erreicht werden, daß die Polflächen weiter radial einwärts angeordnet werden können, wodurch dieser Effekt noch verstärkt wird.

Durch das Merkmal g) wird erreicht, daß sich das Magnetsystem bzw. die das Magnetsystem umgebenden Gehäuseteile und Abschirmungen auf einem floatendem Potential einstellen, bei dem keinerlei Zerstäubung dieser an sich freiliegenden Teile stattfindet.

Insgesamt gesehen, besitzt die erfindungsgemäße Rohrkatode noch die folgenden weiteren Vorteile wie folgt:
- nahezu die gesamten vom Target abgestäubten Atome werden auf dem Substrat niedergeschlagen,
- stab-, rohr- oder drahtförmige Substrate können ohne Substratrotation allseitig beschichtet werden,
- durch Konzentration der abgestäubten Teilchen von einem großen Targetdurchmesser auf die notwendigerweise kleineren Substratdurchmesser ergibt sich eine hohe Beschichtungsrate,
es ist eine einfache Targetmontage ohne Löten, Kleben, Schrauben möglich.

Es ist dabei besonders vorteilhaft, wenn zwei Anoden mit zylindrischen Innenflächen in spiegelsymmetrischer Anordnung zur Katode vorgesehen sind, von denen die eine Anode in Achsrichtung diesseits und die andere Anode in Achsrichtung jenseits der Katode liegt, wobei die zylindrischen Innenflächen der Anoden einen Radius aufweisen, der gleich oder kleiner ist als der Radius der Zerstäubungsfläche des Targets. Auf diese Weise wird eine gute Einkopplung der Anoden in den Stromkreis ermöglicht.

Für die Aufrechterhaltung bzw. Einstellung einer definierten Gasatmosphäre innerhalb der Zerstäubungsvorrichtung ist es besonders vorteilhaft, wenn die Anoden auf den der Katode zugekehrten Seiten je eine ringförmige Gasverteilerleitung tragen, die mit entsprechenden Gasaustrittsöffnungen versehen ist.

Es ist mit einer derartigen Katodenzerstäubungsvorrichtung auch möglich, Mischschichten bzw. Schichten aus einer Quasi-Legierung zu erzeugen, dann nämlich, wenn das Target in axialer Richtung aus unterschiedlichen Werkstoffen zusammengesetzt ist.

Die erfindungsgemäße Katodenzerstäubungsvorrichtung kann in der Weise weiter ausgestaltet werden, daß sie auch zum Zerstäuben von Targets aus ferromagnetischen Werkstoffen geeignet sind.

Dies geschieht in besonders vorteilhafter Weise dadurch, daß das aus ferromagnetischem Werkstoff bestehende Target in drei hohlzylindrische Targetteile unterteilt ist, von denen zwei in Achsrichtung außenliegende Targetteile sich mit dem in der Mitte liegenden Targetteil in Achsrichtung überlappen, in radialer Richtung jedoch in den Überlappungsbereichen je einen Luftspalt gegenüber dem in der Mitte liegenden Targetteil einschließen, dessen radiale Breite "s" kleiner ist als der sich unter den Betriebsbedingungen einstellende Dunkelraum-Abstand.

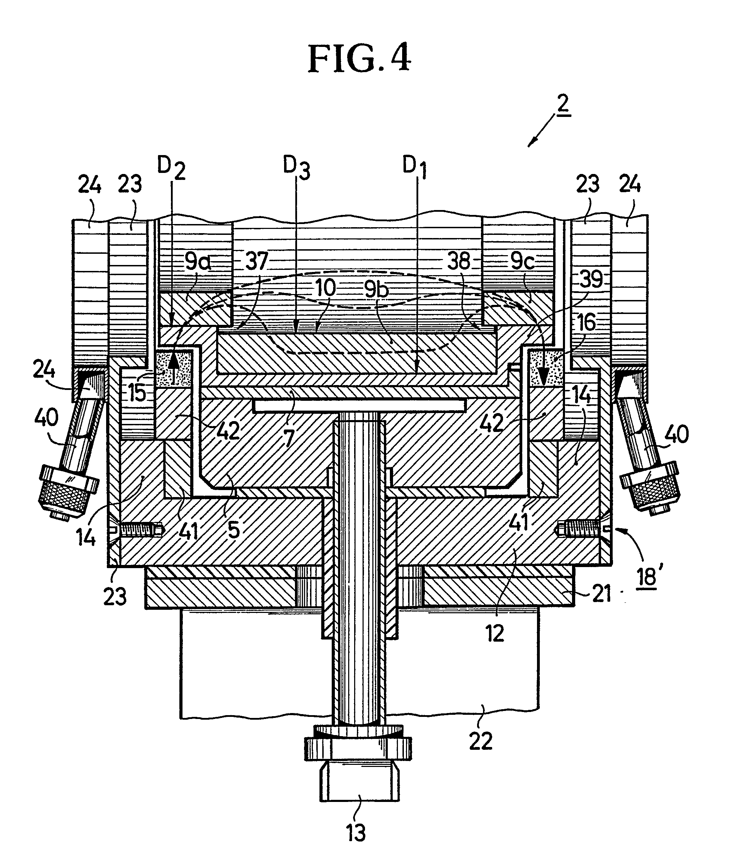

Durch diese Maßnahme wird ein Austritt der Feldlinien aus ferromagnetischen Targetteilen erzwungen, ein Vorgang, der anhand der Figur 4 noch näher erläutert wird.

Zwei Ausführungsbeispiele des Erfindungsgegenstandes werden nachfolgend anhand der Figuren 1 bis 5 näher erläutert.

Es zeigen:

Figur 1 eine Seitenansicht (oben) und einen Axialschnitt (unten) durch eine Magnetron-Rohrkatode mit einem Target aus einem nicht-ferromagnetischen Werkstoff,

Figur 2 eine stirnseitige Ansicht (oben) bzw. einen Radialschnitt (unten) durch den Gegenstand von Figur 1 in geringfügig vergrößertem Maßstab,

Figur 3 eine Seitenansicht und einen Axialschnitt durch eine Magnetron-Rohrkatode mit Targetteilen aus einem ferromagnetischem Werkstoff in einer Darstellung analog Figur 1,

Figur 4 einen Teilausschnitt aus der unteren Hälfte von Figur 3 in vergrößertem Maßstab, und

Figur 5 eine Seitenansicht einer vollständigen Katoden-Anoden-Anordnung einer Katodenzerstäubungsvorrichtung analog Figur 1 oder 3.

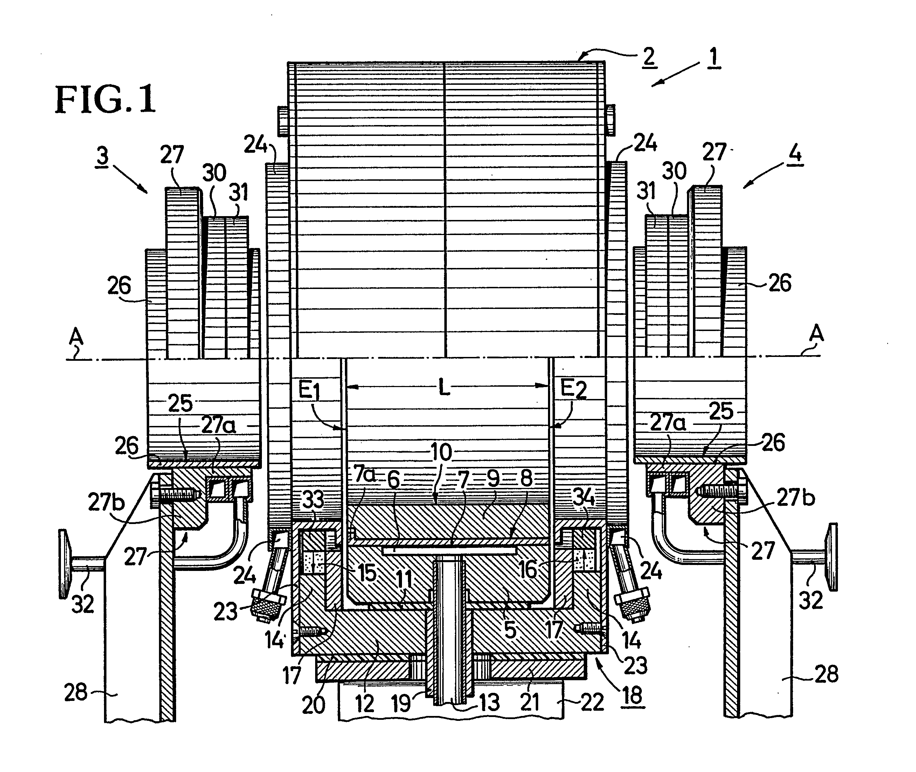

In Figur 1 ist eine Katodenzerstäubungsvorrichtung 1 nach dem Hohl-Magnetronprinzip dargestellt, die aus einem Katodenteil 2 und zwei Anodenteilen 3 und 4 besteht. Sowohl Katodenteil als auch die Anodenteile sind im wesentlichen rotationssymmetrisch zu einer Systemachse A-A ausgebildet.

Im unteren Teil von Figur 1 ist ein ringförmiger Katodengrundkörper 5 gezeigt, der mit einem umlaufenden, ringförmigen Kühlkanal 6 versehen ist. In Richtung auf die Systemachse A-A ist der Kühlkanal 6 durch eine membranartige Wand 7 mit einer zylindrischen Innenfläche 8 verschlossen, in die ein rohrförmiges Target 9 mit einer zylindrischen Zerstäubungsfläche 10 und einer gleichfalls zylindrischen Außenfläche eingesetzt ist. Wie zu erkennen ist, ist das Target 9 als dickwandiges Rohr ausgebildet, hat also eine verhältnismäßig sehr lange Standzeit. An einem Ende der Wand 7 befindet sich eine radial einwärts gerichtete Anschlagschulter 7a für das Target 9.

Der Katodengrundkörper 5 ist unter Zwischenschaltung eines Isolierringes 11 von einem ringförmigen Magnetjoch 12 umgeben, das im Axialschnitt einen C-förmigen Querschnitt hat. Durch das Magnetjoch 12, den Isolierring 11 und den Katodengrundkörper 5 sind zwei Kühlmittelleitungen 13 hindurchgeführt, die in den Kühlkanal 6 einmünden. Im Bereich des Magnetjochs 12 sind die Leitungen 13 von einer Isolierhülse 19 umgeben.

Das Magnetjoch 12 besitzt zwei radial einwärts gerichtete Flansche 14, auf die ein ringförmig geschlossener Kranz von Permanentmagneten 15 und 16 mit entgegengesetzter Pollage aufgesetzt ist. Es ist zu erkennen, daß der lichte Abstand der Permanentmagnete 15 und 16 deutlich größer ist als das Längenmaß L zwischen zwei radialen Ebenen $E_1$ und $E_2$, in denen auch die kreisringförmigen Stirnflächen von Katodengrundkörper 5 und Target 9 liegen.

Die Zwischenräume zwischen den Permanentmagneten 15 und 16 und dem Katodengrundkörper 5 sind größtenteils durch Ringe 17 aus Aluminium ausgefüllt, die beiderseits des Katodengrundkörpers 5 nicht näher bezeichnete Ringspalte freilassen, die so eng gehalten sind, daß sich in ihnen keine Glimmentladung ausbilden kann.

Magnetjoch 12 und Permanentmagnete 15 bilden ein Magnetsystem 18, das durch Isolierabstände, nämlich durch Luftspalte, den Isolierring 11 und die Isolierhülse 19 gegenüber dem Katodengrundkörper 5 gehalten ist. Das Magnetjoch 12 bildet gleichzeitig ein tragendes Teil der gesamten Anordnung und stützt sich über ein weiteres Isolierstoffteil 20 auf dem sektorförmigen Flansch 21 einer Tragstütze ab. Durch diese nach allen Seiten isolierte Befestigung kann sich das Magnetsystem 18 sowohl gegenüber dem Katodengrundkörper als auch gegenüber der auf Massepotential befindlichen Tragstütze 22 hinsichtlich seiner Spannung frei einstellen ("floaten").

Die radialen Stirnflächen des Magnetjochs 12 und die seitlichen Außenflächen der Permanentmagnete 15 und 16 sowie die radial einwärts gerichteten Polflächen der genannten Permanentmagnete sind von je einer aus einem nicht-ferromagnetischen Werkstoff bestehenden Magnetabschirmung 23 abgedeckt, die mit den übrigen Teilen des Magnetsystems 18 elektrisch leitend verbunden sind. Die ringförmigen Magnetabschirmungen 23 besitzen einen L-förmigen Querschnitt, dessen langer Schenkel radial und dessen kurzer Schenkel axial ausgerichtet ist. Auch die Magnetabschirmungen 23 sind mit je einem ringförmigen Kühlkanal 24 ausgestattet, der mit Zu- und Ableitungen 40 versehen ist (siehe auch Figur 4).

Figur 1 ist weiterhin zu entnehmen, daß die beiden Anodenteile 3 und 4 mit zylindrischen Innenflächen 25 versehen sind, wobei die Anordnung 1 mit Isolierabst#nden und spiegelsymmetrisch zur Katode 2 getroffen ist. Dadurch ist die eine Anode 3 in Achsrichtung diesseits und die andere Anode 4 in Achsrichtung jenseits der Katode angeordnet. Die zylindrischen Innenflächen 25 der Anoden weisen dabei einen Radius auf, der kleiner ist als der Radius der Zerstäubungsfläche 10 des Targets 9. Die zylindrischen Innenfläche 25 werden von zylindrischen Rohrabschnitten 26 gebildet, die in den achsparallelen Schenkel 27a eines L-förmigen Ringflansches 27 eingesetzt sind, dessen radial nach außen gerichteter Schenkel 27b unten mit je einer Tragstütze 28 verbunden ist. Die Tragstütze 28 kann sich elektrisch leitend auf einer Innenfläche einer Vakuumkammer 29 abstützen und damit auf Massepotential liegen.

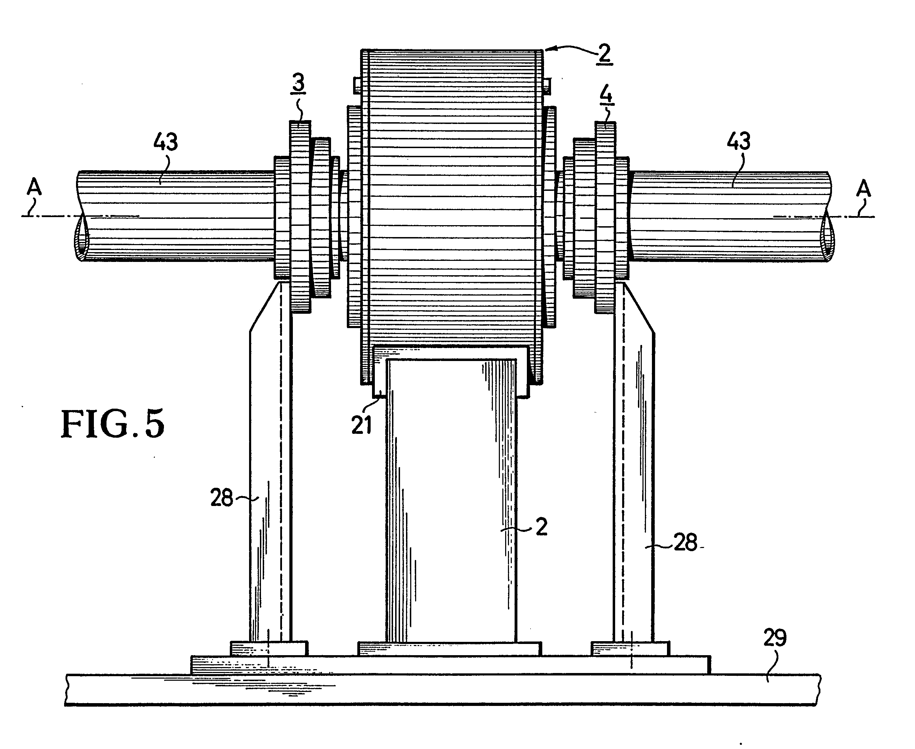

Es ist aber auch möglich, die Tragstützen isoliert an der Vakuumkammer zu befestigen, so daß die Anodenteile 3 und 4 an ein gegenüber Masse positives Potential gelegt werden können, wodurch die Anodenfunktion verstärkt wird (Figur 5). Auch die Anodenteile 3 und 4 sind mit je einem ringförmigen Kühlkanal 30 versehen. Sie besitzen ferner auf den der Katode 2 zugekehrten Seiten je eine ringförmige Gasverteilerleitung 31, die in Richtung auf die Katode 2 mit nicht näher dargestellten perforationsähnlichen Gasaustrittsbohrungen versehen ist. Die Gasverteilerleitungen 31 sind über Anschlußleitungen 32 mit nicht dargestellten Quellen für ein Sputtergas verbunden, das auch eine reaktive Komponente enthalten kann.

Es ist in Figur 1 noch dargestellt, daß auf die radial einwärts gerichteten, dem Magnetjoch 12 abgekehrten achsparallelen Flächen der Permanentmagnete 15 und 16 Polschuhe 33 und 34 aus weichmagnetischem Material aufgesetzt sind. In diesem Fall werden die Polflächen N und S nicht mehr durch die radial einwärts gerichteten Oberflächen der Permanentmagnete 15 und 16 gebildet, sondern durch die Innenflächen der Polschuhe, und zwar sowohl durch die achsparallelen als auch durch die innen liegenden radialen Oberflächenteile der Polschuhe. Die gesamte Anordnung ist auch hier ringförmig geschlossen ausgeführt, und es versteht sich, daß die beiden L-förmigen Magnetabschirmungen 23 - radial einwärts gesehen - auch die Polschuhe 33 und 34 übergreifen bzw. überdecken.

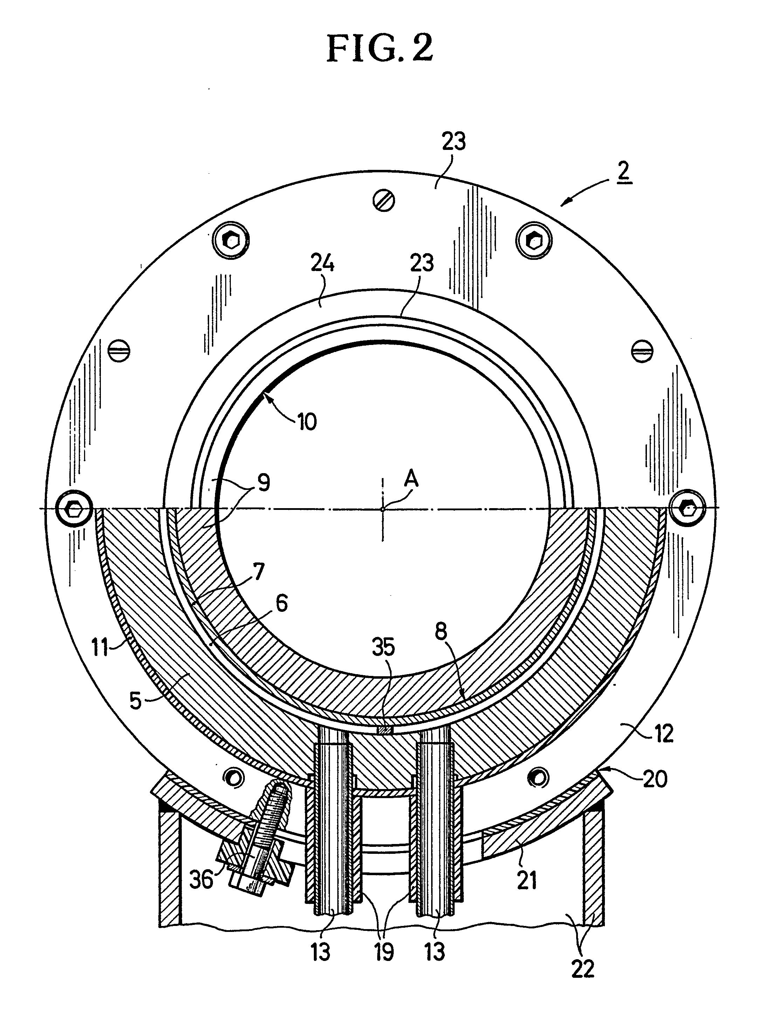

Bei der Darstellung in Figur 2 ist das ansonsten teilweise die Sicht verdeckende Anodenteil weggelassen. Zu erkennen ist noch, daß der Kühlkanal 6 zwischen den beiden Kühlmittelleitungen 13 zur Vermeidung eines Strömungskurzschlusses durch eine Leiste 35 unterbrochen ist. Ansonsten wurden die Bezugzeichen der Figur 1 beibehalten. Durch die Schraube 36 wird auch angedeutet, daß die Tragstütze 22 mit dem Flansch 21 und das Magnetjoch 12 die tragenden Elemente für den übrigen Aufbau der Katode bilden.

Es ist ganz wesentlich, daß das rohrförmige Target 9 nach dem Lösen der in Figur 1 rechts liegenden Magnetabschirmung 23 und der Abnahme der ringförmig angeordneten Polschuhe 34 ganz einfach nach rechts aus der Katode herausgezogen werden kann, wobei es axial von der an Ort und Stelle verbleibenden Wand 7 abgezogen wird. Der Einbau eines neuen Targets 9 geschieht in der umgekehrten Reihenfolge: Das neue Target wird ganz einfach bis zur Anschlagschulter 7a eingeschoben. Das Target hat an der Stelle der Anschlagschulter 7a einen komplementären Rücksprung.

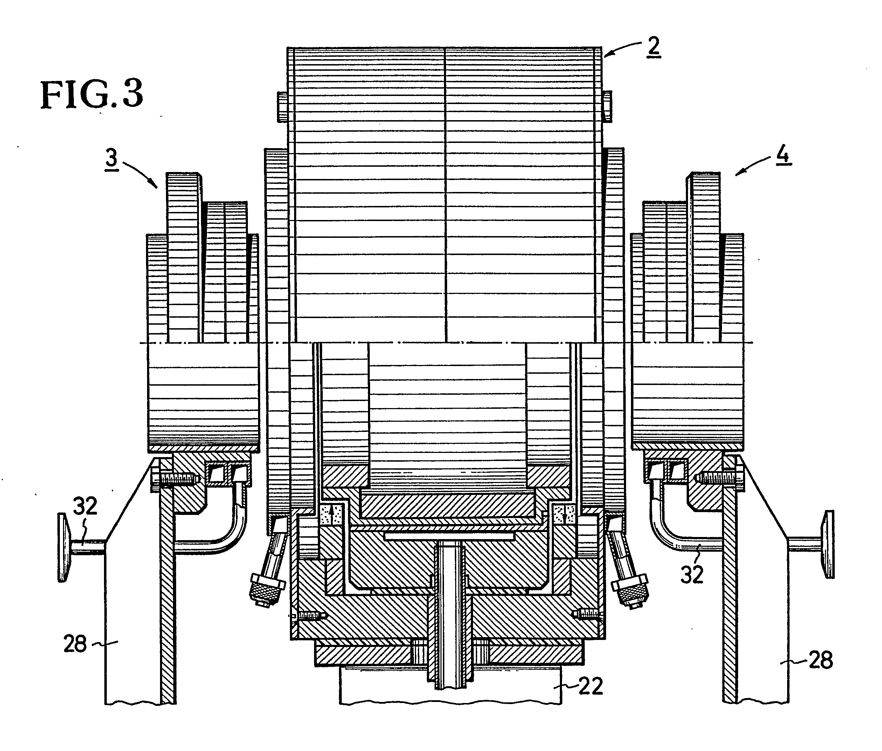

Figur 3 zeigt eine Anordnung, die sehr weitgehende Übereinstimmung mit der Anordnung nach den Figuren 1 und 2 aufweist. Der wesentliche Unterschied wird anhand von Figur 4 erläutert, die einen vergrößerten Ausschnitt aus dem mittleren unteren Teil von Figur 3 zeigt. Gleiche Teile sind auch hier mit gleichen Bezugszeichen versehen.

Das Target 9 besteht aus ferromagnetischem Werkstoff und ist in drei hohlzylindrische Targetteile 9a, 9b und 9c unterteilt. Die beiden in Achsrichtung außenliegenden Targetteile 9a und 9c überlappen sich mit dem in der Mitte liegenden Targetteil 9b und schließen in radialer Richtung in den Überlappungsbereichen je einen Luftspalt 37 bzw. 38 gegenüber dem in der Mitte liegenden Targetteil 9b ein. Die radiale Breite dieses Luftspalts in jedem Falle kleiner als der sich unter den Betriebsbedingungen einstellende Dunkelraum-Abstand, so daß die beim Betrieb brennende Glimmentladung nicht in die Luftspalte 37 und 38 eindringen kann.

Die räumliche Fixierung der Anordnung wird dadurch erreicht, daß die Targetteile 9a, 9b und 9c unter Wahrung von Überlappung und Luftspalten auf einem als zweiteiliger Umdrehungskörper ausgebildeten Targetträger 39 angeordnet sind, der aus amagnetischem Werkstoff besteht und eine gute elektrische und thermische Leitfähigkeit aufweist(Kupfer). Die Targetteile 9a, 9b und 9c bilden mit diesem Targetträger 39 eine bauliche Einheit und können mit ihm von der Wand 7 nach links abgezogen werden (bezogen auf die Figur 4).

Der Targetträger 39 ist, wie in Figur 4 dargestellt, in einem axialen Schnitt in Bezug auf eine radiale Symmetrieebene, in der auch die Achse der Kühlmittelleitung 13 liegt, doppel-Z-förmig ausgebildet. Dadurch wird ein mittlerer hohlzylindrischer Abschnitt mit einem ersten inneren Durchmesser $D_1$ gebildet, der über zwei kreisringförmige radiale Stege mit zwei axial außenliegenden hohlzylindrischen Abschnitten verbunden ist, die einen zweiten inneren Durchmesser $D_2$ aufweisen. Das absolute Maß der Durchmesserdifferenz $D_2 - D_1$ entspricht

der doppelten Wandstärke des mittleren Targetteils 9b plus der doppelten radialen Breite eines jeden der beiden Luftspalte 37 und 38. Andererseits ist der Innendurchmesser $D_2$ der axial außenliegenden Targetteile 9a und 9c um das doppelte radiale Maß eines jeden Luftspalts 37 bzw. 38 kleiner als der Innendurchmesser $D_3$ des mittleren Targetteils.

In besonders zweckmäßiger Weise ist der Targetträger 39 - axial gesehen - in der Mitte unterteilt, und zwar derart, daß die beiden hier nicht gesondert hervorgehobenen Trägerteile in axialer Richtung auf das mittlere Targetteil 9b aufschiebbar sind.

Anhand von Figur 4 ist auch dargestellt, in welcher Weise die beiden Kühlmittelkanäle 24 mit Anschlußleitungen 40 versehen sind.

Bezüglich des hier dargestellten Magnetsystems 18 und seiner magnetischen Eigenschaften, die sich aus der besonderen Anordnung der ferromagnetischen Targetteile 9a, 9b und 9c ergeben, sei noch auf folgendes verwiesen. Durch die Zwischenschaltung der Luftspalte entsteht ein Feldlinienverlauf, der in Figur 4 gestrichelt angedeutet ist. In diesem Falle sind die Flansche 14 des Magnetjochs 12 axial und radial einwärts durch Ringe 41 und 42 aus weichmagnetischem Material verstärkt, wobei die Permanentmagnete 15 und 16 mit entsprechender Pollage (siehe eingezeichnete Pfeile) radial einwärts auf die Ringe 42 aufgesetzt sind. Dadurch können die Permanentmagnete 15 und 16 näher an den mittleren Targetteil 9b herangerückt und in Überlappung mit den Targetteilen 9a und 9c gebracht werden.

Das magnetische Feld überbrückt in jedem Falle teilweise die beiden Luftspalte 37 und 38, teilweise verläuft es jedoch auch unmittelbar vom Targetteil 9a zum Targetteil 9c. Die unterste eingezeichnete Feldlinie würde allein zu zwei ringförmig geschlossenen "Plasmaschläuchen" außerhalb der Luftspalte 37 und 38 führen. In Verbindung mit den eine Art Brücke zwischen den Targetteilen 9a und 9c bildenden Feldlinien wird jedoch auch in dem dazwischenliegenden Bereich des Targetteils 9b ein sehr viel größerer ringförmiger Plasmaschlauch ausgebildet, der zu einer nahezu ganzflächigen Abtragung (Erosion) des mittleren Targetteils 9b führt.

Durch die geometrische Form des Targetträgers 39 bzw. durch das Maß der Überlappung im Bereich der Luftspalte 37 und 38 sowie durch die Verhältnisse der Durchmesser $D_1$, $D_2$ und $D_3$ hat man es in der Hand, den Anteil der durch das mittlere Targetteil 9b fliessenden Feldlinien zu den das mittlere Targetteil als Brücke überspannenden Feldlinien zu variieren. Durch eine sorgfältige Abstimmung ist es möglich, den Erosionseffekt im Bereich der Zerstäubungsfläche 10 auf möglichst homogene Werte über nahezu die gesamte Länge des mittleren Targetteils 9b zu optimieren.

Aus der vorstehenden Beschreibung geht hervor, daß das mittlere Targetteil 9b das eigentliche Target ist, während die beiden äußeren Targetteile 9a und 9c auch als Polschuhe bezeichnet werden können. Die im Merkmal f) des Hauptanspruchs definierte axiale Lage von Polflächen und Target bezieht sich dabei auf die Polflächen der Permanentmagnete 15 und 16 und das mittlere Targetteil 9b.

Die zu beschichtenden Substrate in Form von Drähten, Stäben oder (dünnen) Rohren werden koaxial zur Systemachse A-A durch die Katodenzerstäubungsvorrichtung hindurchbewegt. Die Systemachse A-A definiert damit den Transportweg der Substrate. Spezielle Substrathalterungen oder Führungen (z.B. Rollensysteme) sind der Einfachheit halber nicht dargestellt.

In Figur 5 ist noch gezeigt, daß der Transportweg der Substrate von rohrförmigen Abschirmungen 43 umgeben ist, die an den Anodenteilen 3 und 4 befestigt sind und mit diesen auf gleichem Potential liegen.

Der Ausdruck "Luftspalte" in Verbindung mit den Abständen 37 und 38 besagt nicht notwendigerweise, daß es sich um Hohlräume handelt. Die betreffenden Abstände können auch durch einen nicht-ferromagnetischen Werkstoff ausgefüllt sein.

Zu erwähnen wäre noch, daß das Magnetjoch zum Zwecke des Einsetzens des Katodengrundkörpers aus zwei Halbschalen besteht, die an einer radialen Nahtstelle aneinanderstoßen. Dies ist in den Zeichnungen jedoch nicht besonders hervorgehoben.

## Ansprüche

1. Katodenzerstäubungsvorrichtung mit
a) einer Hohlkatode nach dem Magnetron-Prinzip mit einem mindestens einen Kühlkanal aufweisenden Katodengrundkörper mit einer inneren zylindrischen Aufnahmefläche für ein hohles Target mit einer inneren, gleichfalls im wesentlichen zylindrischen Zerstäubungsfläche und einer zylindrischen Außenfläche, mit einem den Katodengrundkörper außen umgebenden Magnetsystem mit Magnetpolen für die Erzeugung eines rotationssymmetrischen, auf dem Umfang und über der Zerstäubungsfläche geschlossenen Tunnels aus magnetischen Feldlinien,
b) mindestens einer zur Zerstäubungsfläche im wesentlichen koaxialen und außerhalb des von der Zerstäubungsfläche umschlossenen Raumes liegende Anode, und
c) mit einem koaxial durch das Target und die mindestens eine Anode hindurchgeführten Transportweg fir ein zu beschichtendes Substrat,
**dadurch gekennzeichnet,** daß

d) der mindestens eine Kühlkanal (6) in Richtung auf das Target (9) durch eine zum Katodengrundkörper (5) gehörende Wand (7) mit zylindrischer Innenfläche (8) dicht abgeschlossen ist,

e) das rohrförmige Target (9) mit derart engem Spiel axial in die zylindrische Innenfläche (8) der Wand (7) eingeschoben ist, daß das Target (9) spätestens bei Erreichen seiner Betriebstemperatur im Wärmeschluß an der Wand anliegt,

f) das Magnetsystem (18) aus einem rotationssymmetrischen, zum Target (9) konzentrischen, mit radial einwärts gerichteten Permanentmagneten (15, 16) gesetzten Magnetjoch (12) besteht und ringförmig geschlossene Polflächen entgegengesetzter Polarität (N, S) aufweist, von denen die einen Polflächen (N) in Achsrichtung diesseits und die anderen Polflächen (S) in Achsrichtung jenseits der Stirnflächen des Targets (9) und in radialer Richtung auf einem Radius liegen, der gleich oder größer ist als der Radius der Zerstäubungsfläche (10), und daß

g) das Magnetsystem (18) durch Isolierabstände (11, 19, 20) in an sich bekannter Weise auf einem gegenüber dem Target (9) und dem Katodengrundkörper (5) einerseits und dem Anodenpotential andererseits frei einstellbaren ("floatenden") Potential haltbar ist.

2. Katodenzerstäubungsvorrichtung nach Anspruch 1, **dadurch gekennzeichnet,** daß die Stirnflächen von Katodengrundkörper (5) und Target (9) paarweise in gemeinsamen radialen Ebenen ($E_1$; $E_2$) liegen.

3. Katodenzerstäubungsvorrichtung nach Anspruch 1, **dadurch gekennzeichnet,** daß die den Kühlkanal (6) begrenzende Wand (7) mit einer radial einwärts gerichteten Anschlagschulter (7a) für das Target (9) versehen ist.

4. Katodenzerstäubungsvorrichtung nach Anspruch 1, **dadurch gekennzeichnet,** daß auf die radial einwärts gerichteten, dem Magnetjoch (12) abgekehrten achsparallelen Flächen der Permanentmagnete (15, 16) Polschuhe (33, 34) aus weichmagnetischem Material aufgesetzt sind, die die ringförmig geschlossenen Polflächen (N, S) tragen.

5. Katodenzerstäubungsvorrichtung nach Anspruch 1, **dadurch gekennzeichnet,** daß die radialen Stirnflächen des Magnetjochs (12), die seitlichen Außenflächen und die radial einwärts gerichteten Polflächen der Permanentmagnete (15, 16) von je einer aus einem nicht-ferromagnetischen Werkstoff bestehenden ringförmigen Magnetabschirmung (23) abgedeckt sind, die mit den übrigen Teilen des Magnetsystems (18) elektrisch leitend verbunden sind.

6. Katodenzerstäubungsvorrichtung nach Anspruch 5, **dadurch gekennzeichnet,** daß die ringförmigen Magnetabschirmungen (23) einen L-förmigen Querschnitt aufweisen, dessen langer Schenkel radial und dessen kurzer Schenkel axial ausgerichtet ist.

7. Katodenzerstäubungsvorrichtung nach Anspruch 5, **dadurch gekennzeichnet,** daß die Magnetabschirmungen (23) je einen ringförmigen Kühlkanal (24) aufweisen.

8. Katodenzerstäubungsvorrichtung nach Anspruch 1, **dadurch gekennzeichnet,** daß zwei Anodenteile (3, 4) mit zylindrischen Innenflächen (25) in spiegelsymmetrischer Anordnung zur Katode (2) vorgesehen sind, von denen die eine Anode (3) in Achsrichtung diesseits und die andere Anode (4) in Achsrichtung jenseits der Katode (2) liegt, wobei die zylindrischen Innenflächen (25) der Anoden einen Radius aufweisen, der gleich oder kleiner ist als der Radius der Zerstäubungsfläche (10) des Targets (9).

9. Katodenzerstäubungsvorrichtung nach Anspruch 8, **dadurch gekennzeichnet,** daß die Anodenteile (3, 4) zylindrische Rohrabschnitte (26) besitzen, die in den achsparallelen Schenkel (27a) eines L-förmigen Flansches (27) eingesetzt sind, dessen radial nach außen gerichteter Schenkel (27b) mit einer Tragstütze (28) verbunden ist.

10. Katodenzerstäubungsvorrichtung nach Anspruch 9, **dadurch gekennzeichnet,** daß die Anodenteile (3, 4) je einen ringförmigen Kühlkanal (30) aufweisen.

11. Katodenzerstäubungsvorrichtung nach Anspruch 8, **dadurch gekennzeichnet,** daß die Anodenteile (3, 4) auf den der Katode (2) zugekehrten Seiten je eine ringförmige Gasverteilerleitung (31) tragen.

12. Katodenzerstäubungsvorrichtung nach Anspruch 1, **dadurch gekennzeichnet,** daß das Target (9) in axialer Richtung aus unterschiedlichen Werkstoffen zusammengesetzt ist.

13. Katodenzerstäubungsvorrichtung nach Anspruch 1, **dadurch gekennzeichnet,** daß das Target (9) aus ferromagnetischem Werkstoff besteht und in drei hohlzylindrische Targetteile (9a, 9b, 9c) unterteilt ist, von denen zwei in Achsrichtung außen liegende Targetteile (9a, 9c) sich mit dem in der Mitte liegenden Targetteil (9b) in Achsrichtung überlappen, in radialer Richtung jedoch in den Überlappungsbereichen je einen Luftspalt (37, 38) gegenüber dem in der Mitte liegenden Targetteil (9b) einschließen, dessen radiale Breite kleiner ist als der sich unter den Betriebsbedingungen einstellende Dunkelraum-Abstand.

14. Katodenzerstäubungsvorrichtung nach Anspruch 13, **dadurch gekennzeichnet,** daß die Targetteile (9a, 9b, 9c) unter Wahrung von Überlappung und Luftspalten auf einem als Umdrehungskörper ausgebildeten Targetträger (39) aus amagnetischem Werkstoff befestigt sind, der eine gute elektrische und thermische Leitfähigkeit aufweist.

15. Katodenzerstäubungsvorrichtung nach Anspruch 14, **dadurch gekennzeichnet,** daß der Targetträger (39) in einem axialen Schnitt in Bezug auf eine radiale Symmetrieebene doppel-Z-förmig ausgebildet ist, derart, daß ein mittlerer hohlzylindrischer Abschnitt mit einem ersten Außendurchmesser $D_1$ über zwei kreisringförmige radiale Stege mit zwei axial außenliegenden hohlzylindrischen Abschnitten mit einem zweiten Außendurchmesser $D_2$ verbunden ist, wobei das absolute Maß der Durchmesserdifferenz $D_2 - D_1$ der doppelten Wandstärke des mittleren Targetteils (9b) plus der doppelten radialen Breite des Luftspalts (37, 38) entspricht.

16. Katodenzerstäubungsvorrichtung nach Anspruch 13, **dadurch gekennzeichnet,** daß der Außendurchmesser D2 der axial außenliegenden Targetteile (9a, 9c) um das radiale Maß kleiner ist als der Innendurchmesser D3 des mittleren Targetteils (9b).

17. Katodenzerstäubungsvorrichtung nach Anspruch 15, **dadurch gekennzeichnet,** daß der Targetträger (39) - axial gesehen - in der Mitte unterteilt ist, derart, daß die beiden Trägerteile axial auf das mittlere Targetteil (9b) aufschiebbar sind.

FIG.1

FIG. 2

FIG.3

# FIG.4

FIG.5

EP 0 376 017 A2